Europäisches Patentamt

European Patent Office

Office européen des brevets

(11) Publication number: **0 430 239 A1**

## EUROPEAN PATENT APPLICATION

(21) Application number: 90122852.8

(22) Date of filing: 29.11.90

(51) Int. Cl.⁵: **H01L 23/495**

(30) Priority: 30.11.89 JP 311336/89

(43) Date of publication of application:
**05.06.91 Bulletin 91/23**

(84) Designated Contracting States:
**DE FR GB Bulletin**

(71) Applicant: **Kabushiki Kaisha Toshiba
72, Horikawa-cho Saiwai-ku
Kawasaki-shi(JP)**

(72) Inventor: **Komenaka, Kazuichi, Intellectual
Prop. Division
Kabushiki Kaisha Toshiba, 1-1 Shibaura
1-chome
Minato-ku, Tokyo 105(JP)**

(74) Representative: **Lehn, Werner, Dipl.-Ing. et al
Hoffmann, Eitle & Partner Patentanwälte
Arabellastrasse 4
W-8000 München 81(DE)**

(54) Resin molded semiconductor device having tab kept at desired electric potential.

(57) A semiconductor device includes a lead frame having a tab (1) and outer leads (4) arranged at both sides of the tab, and a semiconductor chip (3) having electrode pads (5) at a pheriphery thereof. The semiconductor chip (3) is adhered through an insulating adhesive to the tab (1) integrally formed of an outer lead (4'). Therefore, since the tab (1) is used as one of wiring layers in the semiconductor device, it is possible to apply an electric potential different from that of the tab to the semiconductor chip.

EP 0 430 239 A1

## RESIN MOLDED SEMICONDUCTOR DEVICE HAVING TAB KEPT AT DESIRED ELECTRIC POTENTIAL

This invention relates to a resin molded semiconductor device, and more particularly to a resin molded semiconductor device having a tab kept at a desired potential.

In a conventional semiconductor device, a semiconductor chip is bonded to a tab of a lead frame in such a manner that they are electrically connected to each other through a conductive adhesive such as silver pastes using epoxy system resins as a base material.

Circuit elements with a fine structure have been required as elements formed in the semiconductor chip. Therefore, it is necessary to reduce the line width even in wiring layers within the chip. The wiring layers include various signal lines such as input signal lines and output signal lines, and power supply lines for applying a desired electric potential to the circuit elements formed in the semiconductor chip. In general, the power supply lines are arranged on the periphery of the chip so as to surround the element regions. With this arrangement of the power supply lines, the wiring design can be facilitated.

However, with a decrease in the line width of the wiring layers, particularly, the resistance of the power supply lines may be increased. When the resistance of the power supply lines is increased, unwanted noise may be remarkably produced and the operation speed of the semiconductor device may be lowered.

Accordingly, an object of this invention is to provide a semiconductor device in which the unwanted noise, caused by the increase in the resistance of the power supply line, is suppressed to a minimum and the operation speed is increased.

According to one aspect of this invention, there is provided a semiconductor device which includes a lead frame having a tab and outer leads arranged at both sides of the tab, and a semiconductor chip having electrode pads at a periphery thereof. The semiconductor chip is adhered through an insulating adhesive to the tab integrally formed of an outer lead. Therefore, since the tab is used as one of wiring layers in the semiconductor device, it is possible to apply an electric potential different from that of the tab to the semiconductor chip.

The novel and distinctive features of the invention are set forth in the claims appended to the present application. The invention itself, however, together with further objects and advantages thereof may best be understood by reference to the following description and accompanying drawings in which:

Fig. 1 is a plan view showing a semiconductor device according to one embodiment of the invention;

Fig. 2 is a cross-sectional view taken along the line A-A' of Fig. 1;

Fig. 3 is a cross-sectional perspective view taken along the line B-B' of Fig. 1;

Fig. 4 is a plan view showing a semiconductor device according to a second embodiment of the invention;

Fig. 5 is a cross-sectional view taken along the line C-C' of Fig. 4; and

Fig. 6 is a cross-sectional perspective view taken along the line D-D' of Fig. 4.

There will now be described a semiconductor device according to embodiments of the invention with reference to the accompanying drawings.

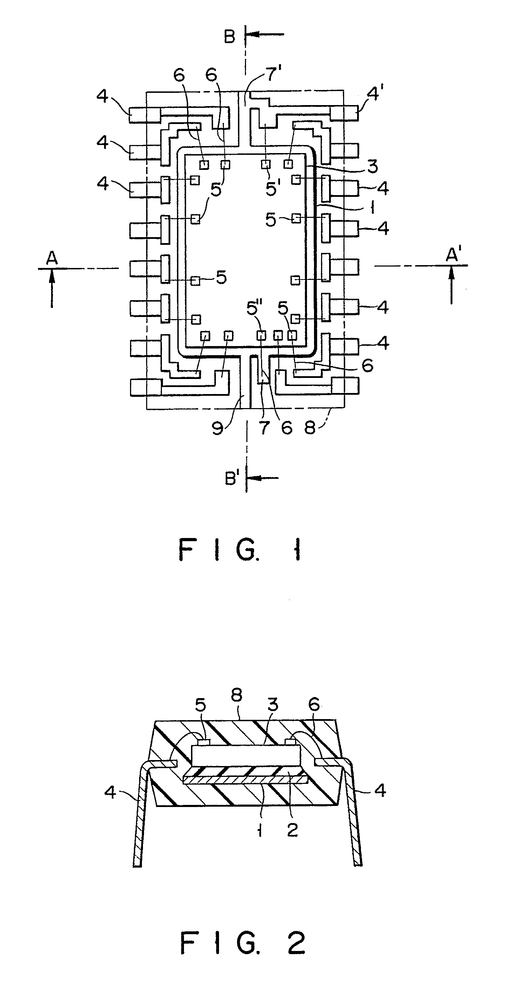

As shown in Figs. 1, 2 and 3, a semiconductor chip 3 is adhered to a tab 1 through an insulating adhesive 2. For example, epoxy system adhesives (not containing silver, for example) or silicone system adhesives may be used as the insulating adhesives 2. A plurality of leads 4 and a lead 4' which are used as external terminals are provided at the periphery of the semiconductor chip 3. The lead 4' among the leads is integrally formed with the tab 1, and therefore the potential of the lead 4' is the same as that of the tab 1. For example, if the lead 4' is connected to a GND terminal (0 V), the potential of the tab 1 is kept at 0 V. The potential of the tab 1 is not applied to the semiconductor chip 3 since the tab is adhered through the insulating adhesive 2 thereto. As a result, it is possible to apply a different potential to the semiconductor chip 3 and the tab 1, respectively.

A plurality of leads 4 are electrically connected through bonding wires 6 to a plurality of electrode pads 5 provided on the semiconductor chip 3. Likewise, the lead 4' is electrically connected to an electrode pad 5' through a bonding wire 6. Further, according to the invention, it is possible to apply a specific potential, for example, GND potential (0 V) to the tab 1. Therefore, since the tab 1 is used as an additional member of the specific lead 4', the potential of the lead 4' can be applied to a portion, for example, an electrode pad 5" which is located far apart from the lead 4'. That is, by using the tab 1 as the additional member of the lead 4', its potential can be applied to the electrode pad 5" which is disposed at the opposite side of the lead 4' and which cannot be directly bonded to the lead 4' through a bonding wire.

Further, in the above embodiment, the tab 1 is provided with projected portions 7 and 7' at both sides so as to perform the wire bonding between the tab 1 and the pad 5". Electrical connections between the projected portion 7 and the pad 5" and between the projected portion 7' and the pad 5' are carried out through bonding wires 6. The device (except part of the leads 4 and 4' used as external terminals) is sealed with a resin layer 8.

The semiconductor device according to the first embodiment of the invention has the structure as described above.

In the semiconductor device according to the first embodiment, the potential of the specific lead 4' can be simultaneously applied to the pad 5' which is located near the lead 4' and the pad 5" which is disposed at the opposite side of the lead 4', for example. As a result, it becomes possible to apply the potential from a plurality of pads, for example, pads 5' and 5" to the wiring layers arranged in the semiconductor chip 3. Thus, a plurality of pads kept at the same potential can be provided on the semiconductor chip 3. Further, since the tab 1 can also serve as a lead member, it is possible to apply the potential from the lead 4' to the pads 5' and 5". That is, it is not necessary to increase the number of external terminals (pins). Since a plurality of pads such as pads 5' and 5" are provided on one wiring layer, for example, GND power supply line, unwanted problems of the noise and the decreased operation speed, which are produced by the increase in the resistance of the power supply line caused by reducing the line width of the wiring layer, may be eliminated to provide a semiconductor device having the reduced noise and the improved operation speed.

As described above, the feature of the invention is that the potential of the tab 1 can be set regardless of the potential of the semiconductor chip 3. Such a feature is not only applied to the first embodiment but also applied to various semiconductor devices. For example, the tab 1 may be connected to a signal input or output lead. With this connection, a plurality of pads with the same potential to which the signal is applied can be provided on the semiconductor chip 3, thereby reducing the influence of the noise and increasing the operation speed. In addition, application of the potential to a plurality of pads can be attained by use of only one lead, that is, only one external terminal.

Further, according to the invention, in addition to the above described advantages, since a plurality of pads having the same potential are provided on the semiconductor chip, the number of pads may not be limited to one, thereby remarkably improving the degree of freedom associated with the device design.

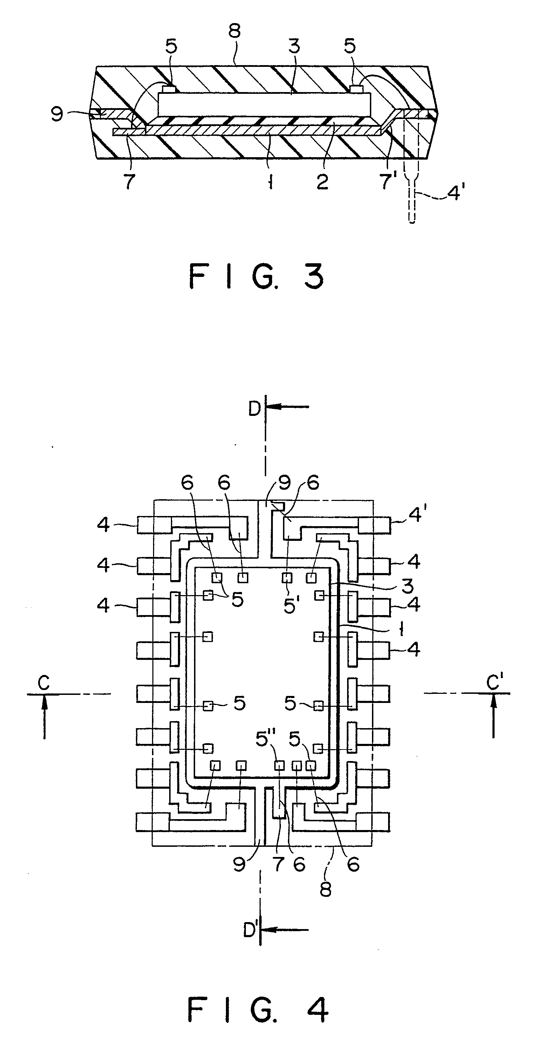

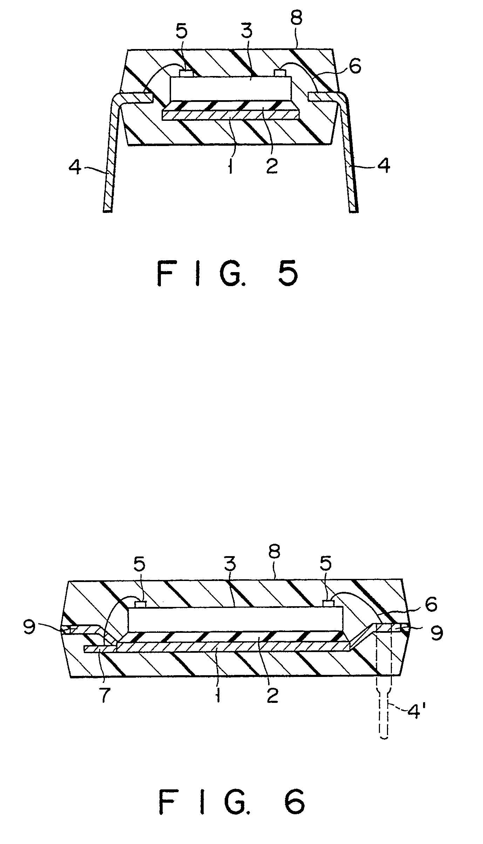

Next, a semiconductor device according to a second embodiment of the invention is described with reference to Figs. 4, 5 and 6.

In Figs. 4, 5 and 6, portions which are the same as those shown in Figs. 1, 2 and 3 are denoted by the same reference numerals and the explanation therefor is omitted.

The feature of the second embodiment is that a lead 4' and a tab 1 are not integrally formed and they are electrically connected by means of a bonding wire 6.

According to the structure, like the first embodiment, the tab 1 can be kept at a desired potential. Therefore, the same advantages as those of the first embodiment may be obtained.

In the first and second embodiments, the pad 5" and the tab 1 may be electrically connected to each other through the bonding wire by forming the projected portion 7.

Further, the tab 1 is generally provided with a projected portion called a suspension pin 9 (refer to Figs. 1 and 4). Of course, it may be possible to use the suspension pin 9 instead of the projected portion 7.

As described above, according to the invention, a semiconductor device will be provided wherein the unwanted noise, caused by the increase in the resistance of the power supply line, is suppressed to a minimum and the operation speed is increased.

It is further understood by those skilled in the art that the foregoing description is preferred embodiments of the disclosed and that various changes and modifications may be made in the invention without departing from the spirit and scope thereof.

Reference signs in the claims are intended for better understanding and shall not limit the scope.

## Claims

1. A semiconductor device including a lead frame having a tab (1) and outer leads (4) arranged at both sides of said tab, and a semiconductor chip (3) having electrode pads (5) at a pheriphery thereof,
   characterized in that said semiconductor chip (3) is adhered to said tab (1) through an insulating adhesive (2), whereby it is possible to apply an electric potential different from that of said tab to said semiconductor chip.

2. The semiconductor device according to claim 1,
   characterized in that said tab (1) is used as a power supply line kept at a ground potential.

3. The semiconductor device according to claim 1,
   characterized in that said semiconductor chip (3) has at both sides a specific electrode pad (5')(5") kept at a desired electric potential.

4. The semiconductor device according to claim 3,

characterized in that said specific electrode pad (5')(5") is used as a ground pad kept at a ground potential.

5. The semiconductor device according to claim 1,

characterized in that said tab (1) includes a projected portion (7) (7') extending from both sides thereof.

6. The semiconductor device according to claim 3,

characterized in that said tab (1) has an outer lead (4') integrally formed with said projected portion (7').

7. The semiconductor device according to claim 3,

characterized in that said specific electrode pad (5' ) (5") is electrically connected to said projected portion (7')(7) through a bonding wire (6).

# FIG. 1

# FIG. 2

# F I G. 3

# F I G. 4

F I G. 5

F I G. 6

European Patent Office

# EUROPEAN SEARCH REPORT

Application Number

## EP 90 12 2852

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 13, no. 574 (E-863) 19 December 1989, & JP-A-01 239962 (NEC IC MICROCOMPUT SYST LTD) 25 September 1989, * the whole document * | 1-7 | H 01 L 23/495 |
| A | PATENT ABSTRACTS OF JAPAN vol. 12, no. 094 (E-593) 26 March 1988, & JP-A-62 226649 (TOSHIBA CORP.) 05 October 1987, * the whole document * | 1-7 | |
| A | PATENT ABSTRACTS OF JAPAN vol. 13, no. 298 (E-784) 10 July 1989, & JP-A-01 077152 (HITACHI LTD) 23 March 1989, * the whole document * | 1-7 | |

TECHNICAL FIELDS
SEARCHED (Int. Cl.5)

H 01 L

The present search report has been drawn up for all claims

| Place of search | Date of completion of search | Examiner |
|---|---|---|
| The Hague | 07 March 91 | ZEISLER P.W. |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document